# EUROPEAN PATENT SPECIFICATION

(11) **EP 4 361 091 B1**
(45) Date of publication and mention of the grant of the patent: **26.11.2025**
(21) Application number: 23203161.7
(22) Date of filing: 12.10.2023
(51) Int. Cl.: B81C 1/00

(54) **PROCESS FOR MANUFACTURING A DEVICE COMPRISING TWO SEMICONDUCTOR DICE AND DEVICE SO OBTAINED**
VERFAHREN ZUR HERSTELLUNG EINER VORRICHTUNG MIT ZWEI HALBLEITERCHIPS UND SO ERHALTENE VORRICHTUNG
PROCÉDÉ DE FABRICATION D'UN DISPOSITIF COMPRENANT DEUX PUCES SEMI-CONDUCTRICES ET DISPOSITIF AINSI OBTENU

(30) Priority: 31.10.2022 IT 202200022395
(43) Date of publication of application: 01.05.2024
(73) Proprietor: STMicroelectronics S.r.l., 20864 Agrate Brianza (MB) (IT)
(72) Inventor: SHAW, Mark Andrew, 20133 MILANO (IT); CORSO, Lorenzo, 20871 RUGINELLO (MB) (IT); GARAVAGLIA, Matteo, 20013 MAGENTA (MI) (IT); ALLEGATO, Giorgio, 20900 MONZA (MB) (IT)
(74) Representative: Studio Torta S.p.A.

(56) References cited:
- US-A1- 2007 158 787
- US-A1- 2014 015 123
- US-A1- 2015 115 378
- US-B2- 11 111 137

## Description

The present invention relates to a process for manufacturing a device comprising two semiconductor dice and to the device so obtained. In particular, the following description refers to a Chip Scale Package - CSP - device, comprising a MEMS (Micro-Electro-Mechanical-System) die, for example a MEMS sensor, and a semiconductor die integrating electronic components, for example an ASIC (Application Specific Integrated Circuit).

As known, dice integrating a MEMS device are protected on one side (generally the top side) by a cap, often made by another die. Furthermore, they are normally associated with dice containing electronic circuits for controlling and/or preprocessing signals and data supplied by the MEMS device (ASIC - Application Specific Integrated Circuit), so as to form a MEMS device. In the following, therefore, reference will be made to a system formed by a MEMS die and the ASIC thereof, without losing generality.

Nowadays, in a MEMS device of the indicated type, the MEMS die and the cap thereof are stacked with the ASIC-integrating die and are carried by an organic substrate with LGA (Land Grid Array) external coupling.

In fact, the stacked arrangement allows reducing the area of the system and allows its use in portable and wearable electronic apparatuses and systems.

However, the desire to use more and more MEMS devices in electronic systems and apparatuses having small dimensions (e.g. in smart watches, earphones, etc.) entails a request for ever smaller dimensions of the MEMS devices, both regarding the area and the thickness thereof.

For example, Italian patent 102013902204294 (corresponding to US patent 9,327,964) describes a method for manufacturing a die assembly which uses the die integrating the ASIC as a cap of the MEMS die, thus saving a die.

Other patents (for example US 9,527,727) teach other solutions teaching stacking a MEMS die on a cap and on an ASIC die, using through vias.

However, the use of through vias is expensive and these solutions do not allow integration of all parts of the system in a same package (CSP - Chip Scale Package - device).

US 2014/015123 A1 discloses a sensor package comprising a first and a second die coupled together through internal connection regions and having external connection regions partially protruding from a moulding compound.

US 2007/158787 A1 discloses another integrated microsystem-on-a-chip and the manufacturing process thereof that uses a carrier wafer, then removed.

The aim of the present invention is to find a solution overcoming the limitations of the prior art.

According to the present invention, a process for manufacturing a microelectromechanical device and a microelectromechanical device are provided, as defined in the attached claims.

For a better understanding of the present invention, some embodiments thereof are now described, purely by way of non-limiting example, with reference to the attached drawings, wherein:
- Figures 1-9 are cross-sections of a semiconductor wafer in subsequent manufacturing steps, according to an embodiment that does not belong to the invention;
- Figure 10 is a cross-section of a portion of the wafer of Figure 9 after a dicing step;
- Figure 11 is a top perspective view of the wafer portion of Figure 10;
- Figure 12 is a cross-section similar to Figure 10, in a subsequent manufacturing step;
- Figure 13 is a top perspective view, similar to Figure 11, of the wafer portion of Figure 12;
- Figure 14 is a cross-section of a device obtained by encapsulating the portion of Figure 12;
- Figure 15A is a top perspective view of the device of Figure 14, in ghost view;
- Figure 15B is a top perspective view of the device of Figure 14;
- Figure 16 is a cross-section of a different embodiment of the process of Figures 1-15B, in a subsequent step to Figure 9;
- Figure 17 is a cross-section of a device obtained after dicing the wafer of Figure 16;
- Figures 18-27 are cross-sections of a semiconductor wafer in subsequent manufacturing steps, according to an embodiment of the invention;
- Figure 28 is a cross-section of a portion of the wafer of Figure 27 after a dicing step;
- Figure 29 is a top perspective view of the wafer portion of Figure 28;
- Figure 30 is a cross-section similar to Figure 28, in a subsequent manufacturing step;
- Figure 31 is a top perspective view, similar to Figure 29, of the wafer portion of Figure 30; and
- Figure 32 is a cross-section of a device obtained by packaging the portion of Figures 30, 31.

The following description refers to the arrangement shown; consequently, expressions such as "above", "below", "top", "bottom", "right", "left" refer to the attached Figures and are not to be interpreted in a limiting manner.

The process for manufacturing a MEMS device described herein uses three wafers, i.e. a MEMS wafer, an ASIC wafer and a carrier wafer, which is eliminated so as to have a reduced final thickness.

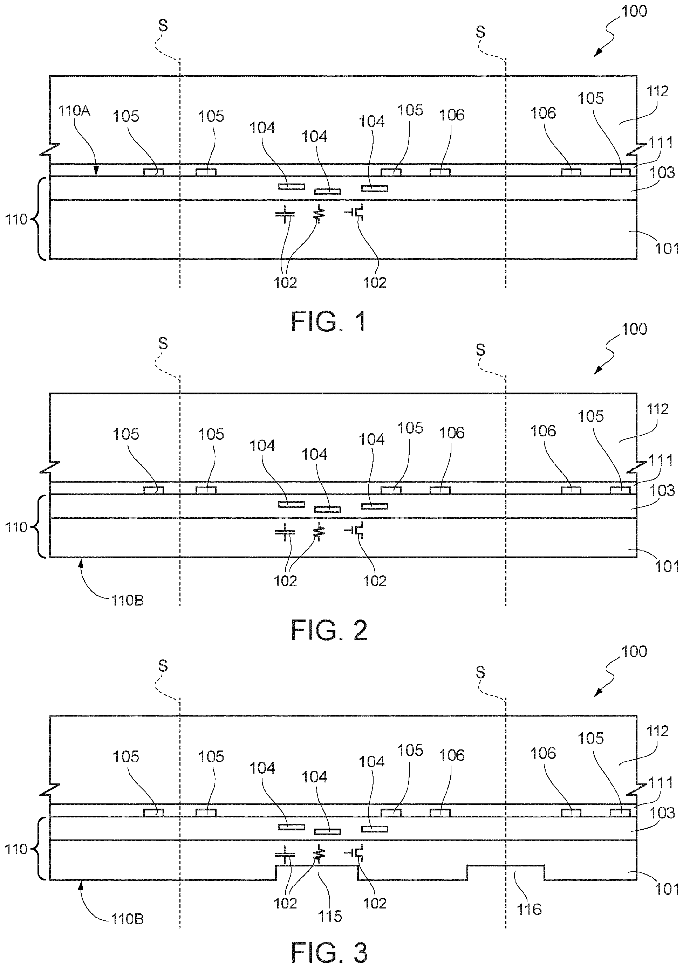

In particular, Figures 1-9 show subsequent steps of a process that does not belong to the invention for manufacturing a composite wafer, indicated by 100, which is subsequently diced along scribe central lines S, shown in dashed lines, intended to separate different dice, indicated by 140, as explained in detail below.

In Figures 1-9, therefore, the portion arranged between two scribe central lines S of the composite wafer 100 (central portion in Figures 1-9) is intended, after dicing and packaging, to form a single device (MEMS device) and the portions to the left and right of the single device represent portions of further devices. In the example shown, the left and right portions of the central portion are arranged symmetrically with respect to the respective adjacent scribe central lines S.

Figure 1 shows the composite wafer 100 obtained after known initial processing steps and including:
forming, in a body 101 of semiconductor material such as silicon, electronic components, indicated generically by 102, and forming an electronic circuit;
forming a passivation layer 103 above the body 101, including forming electrical contact regions and connections, of conductive material, for example of metal such as aluminum, towards the electronic components 102 (metallizations 104) and towards contact regions, including first and second contact pads 105, 106. The metallizations 104 may form a connection structure known as RDL (Redistribution Layer). The body 101 and the passivation layer 103 form an ASIC wafer 110. The passivation layer 103 forms a main surface (hereinafter referred to as the front surface 110A of the ASIC wafer 110). The first and second contact pads 105, 106 have the purpose of electrically connecting the electronic components 102 to each other and towards the outside and are arranged above the passivation layer 103 or are recessed with respect thereto, so as not to protrude therefrom, in a manner known to the person skilled in the art. The contact pads 105, 106 are of conductive material, such as copper. As clarified below, in the embodiment shown, the first contact pads 105 are intended for allowing outward connection through bumps, the second contact pads 106 are intended for allowing internal connection through wires;
forming a carrier wafer bonding layer 111 on the front surface 110A of the ASIC wafer 110. For example, the carrier wafer bonding layer 111 is a metal or a metal alloy such as AuSn; alternatively, it may be of CuSn or AlGe AuSn, AuGe, AuSi, AlSi; and
bonding a carrier wafer 112 to the ASIC wafer 110, using the carrier wafer bonding layer 111. For example, the carrier wafer 112 may be of semiconductor material such as silicon or glass. Bonding is carried out at high temperatures, such as over 200°C, and constitutes a temporary bonding.

In Figure 2, the body 101 is thinned and polished from the back, until it reaches a small thickness, for example 100-120 µm. Thus, another main face is formed, hereinafter referred to as the rear surface 110B of the ASIC wafer 110.

In Figure 3, a first cavity 115 and a second cavity 116 are formed in the body 101 from the rear surface 110B. In particular, a photolithographic process is used, including definition of a resist mask and silicon etching; then the masking resist is removed. As better explained below, the first cavity 115 is intended to be arranged above the movable structures of the MEMS wafer (to be bonded); the second cavity 116 is intended to be arranged above contact pads of the MEMS wafer.

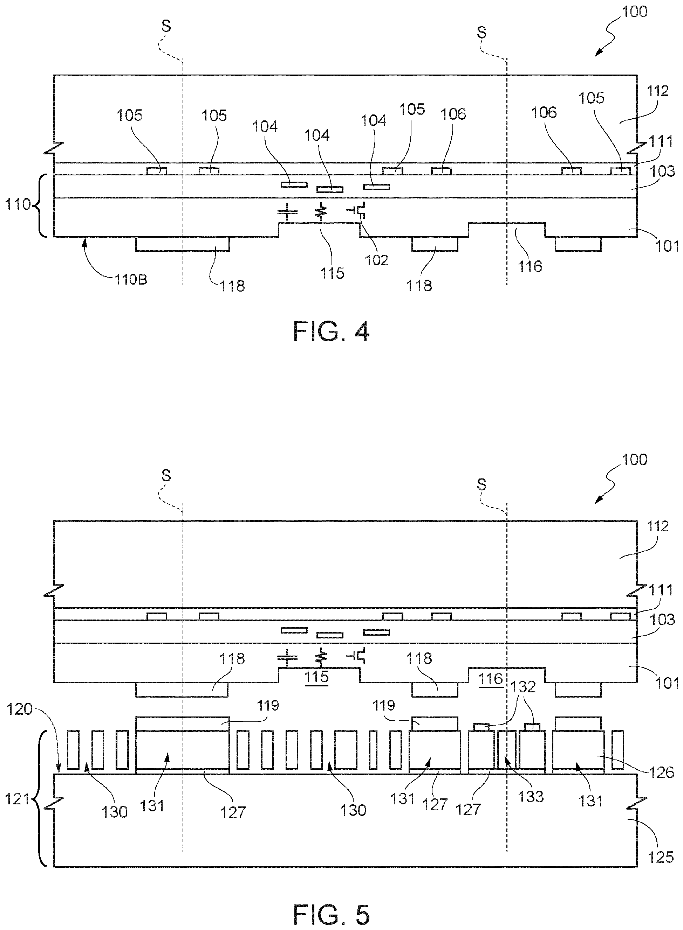

In Figure 4, first bonding regions 118 are formed on the rear surface 110B of the ASIC wafer 110. For example, the first bonding regions 118 may be of AuSn, selectively deposited on the sides of the cavities 115, 116.

In the process illustrated, similar bonding regions (second bonding regions 119) are formed on a front surface 120 of a MEMS wafer 121, as shown in Figure 5. The second bonding regions 119 may also be of AuSn.

The MEMS wafer 121 here comprises a first semiconductor layer 125 and a second semiconductor layer 126, for example both of silicon. The first and the second semiconductor layers 125, 126 are mutually superimposed and integral through dielectric regions 127. The dielectric regions 127 electrically insulate the first and the second semiconductor layers 125, 126, where provided, but may be interrupted for forming semiconductor or metal electrical connections, in a known manner.

The first semiconductor layer 125, for example a substrate or a substrate and an epitaxial layer, generally does not accommodate electrical structures, except for possible electrical connections, not shown.

The second semiconductor layer 126 forms sensitive regions or suspended actuation regions. To this end, the second semiconductor layer 126 has through openings which delimit suspended structures, indicated generically by 130 in Figures 5-14. As obvious to the person skilled in the art, the suspended structures 130 are supported by suspension structures, which may be both of the elastic type (springs) and of the rigid type (along one or more directions) and extend between the suspended structures 130 and anchoring regions 131. The anchoring regions 131 are generally formed by the same second semiconductor layer 126 and integral with the first semiconductor layer 125 through the dielectric regions 127.

In a known manner, the suspension structures (not shown) allow the movement of the suspended structures 130 according to one or more degrees of freedom, based on the desired function.

The second bonding regions 119 are generally formed on the anchoring regions 131 or in any case on other fixed portions of the second semiconductor layer 126.

Third contact pads 132 extend on other fixed portions (indicated by 133 in Figure 5) of the MEMS wafer 121, also formed in the second semiconductor layer 126 and fixed to the first semiconductor layer 125 through the dielectric regions 127.

In Figure 5, the body 101 is bonded to the MEMS wafer 121 through the first and the second bonding regions 118, 119 which are here mutually aligned. Bonding occurs at a temperature such as to allow adhesion and bonding between the first and the second bonding regions 118, 119, for example at 270°C.

As is noted in Figure 5, the geometry is designed and the bonding of the ASIC wafer 101 to the MEMS wafer 121 is performed so that the first cavity 115 faces the suspended structures 130 (to allow the movement thereof without limitations) and the second cavity 116 faces the third contact pads 132 (to allow the electrical connection thereof, as described below).

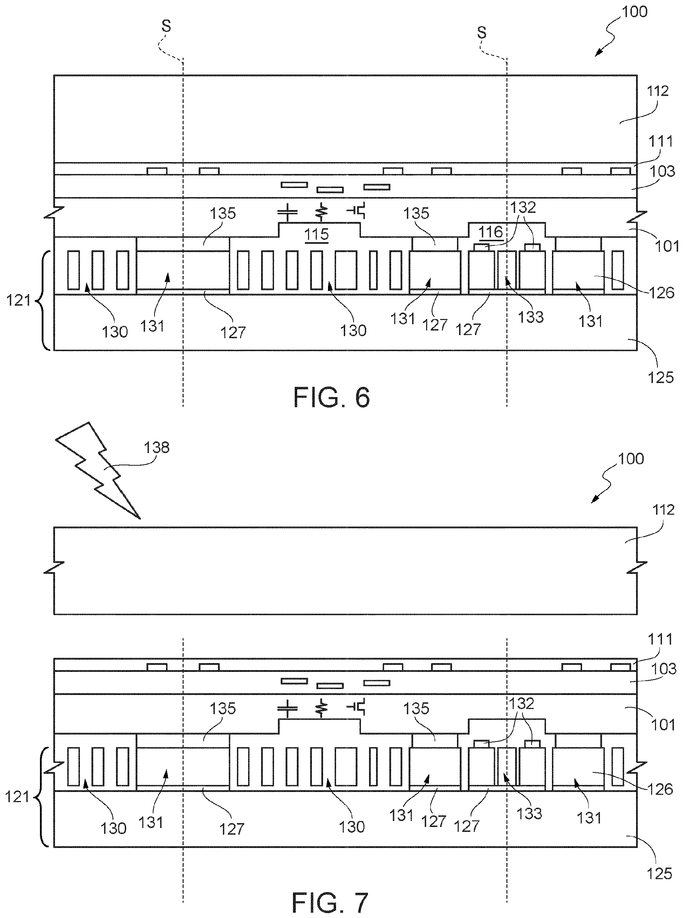

After bonding (Figure 6), the first and the second bonding regions 118, 119 are joined to form common bonding regions 135.

The composite wafer 100 is then thinned from the back, so as to reduce the thickness of the first semiconductor layer 125 down to a small value, for example 100-120 µm.

In Figure 7, the carrier wafer 112 is removed. For example, in case of a carrier wafer 112 of glass, laser light may be used, indicated schematically in Figure 7 by 138. Alternatively, the detachment may be obtained thermally. In this manner, the composite wafer 100 (apart from the residues of the carrier wafer bonding layer 111) is reduced to a very small thickness, for example 0.25 mm.

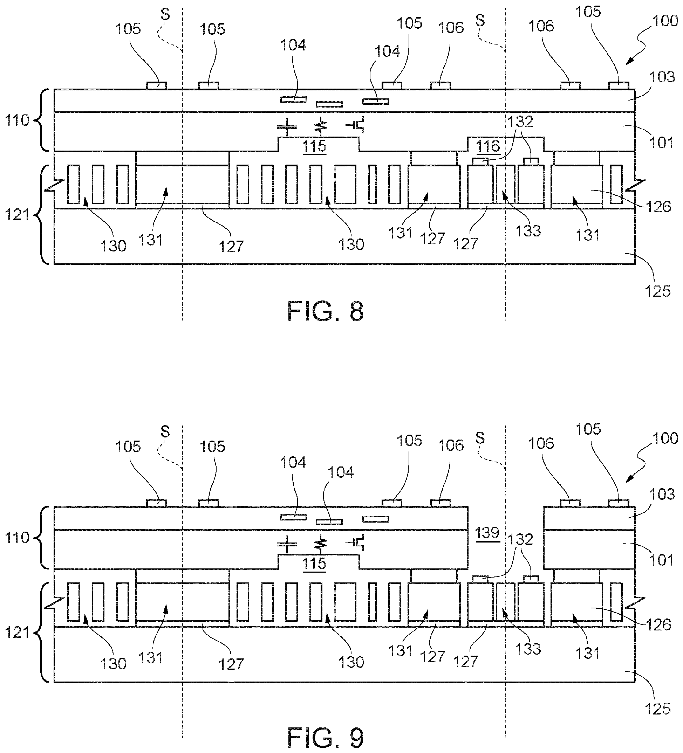

Subsequently, Figure 8, the residues of the carrier wafer bonding layer 111 are completely removed, using a suitable solvent, such as a long chain apolar organic solvent.

As a result, the first and the second contact pads 105, 106 become accessible on the front of the composite wafer 100.

In Figure 9, the portions of the body 101 and of the passivation layer 103 above the second cavity 116 are removed. For example, the body 101 and the passivation layer 103 may be diced by a dicing saw or such portions may be removed by masked etchings. A through opening 139 (incorporating the second cavity 116), which makes the third contact pads 132 accessible from the outside, is therefore formed in the ASIC wafer 110.

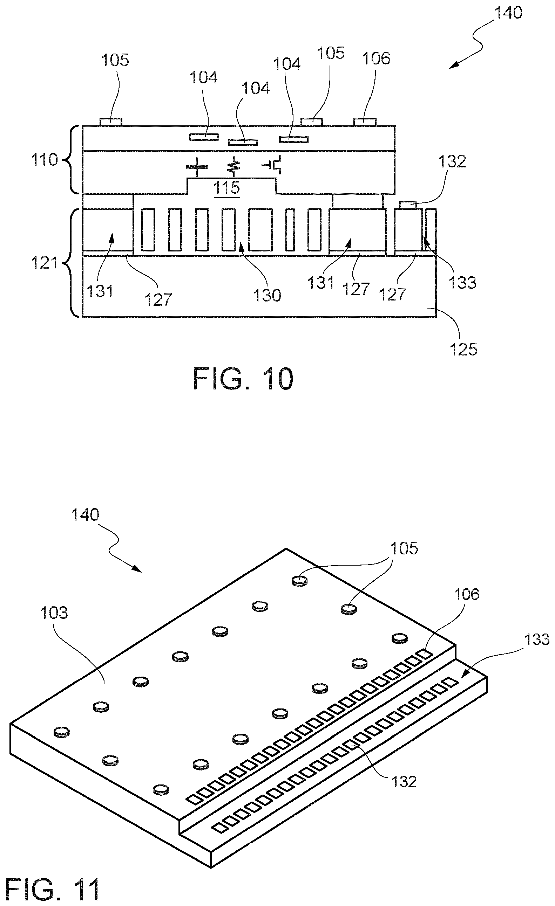

The composite wafer 100 of Figure 9 is then singulated along the scribe central lines S. The dicing may occur using dicing saw or by laser dicing, in a per se known manner, thereby obtaining a composite die 140, as shown in Figure 10. Hereinbelow, for ease of understanding, the portions of the wafers and layers of the composite wafer 100 forming the composite die 140 and obtained from the singulation operation are indicated with the same reference numbers used for the composite wafer 100.

Figure 11 is a top perspective view of the composite die 140 of Figure 10, showing the first and the second contact pads 105, 106 and the third contact pads 132, placed on different levels.

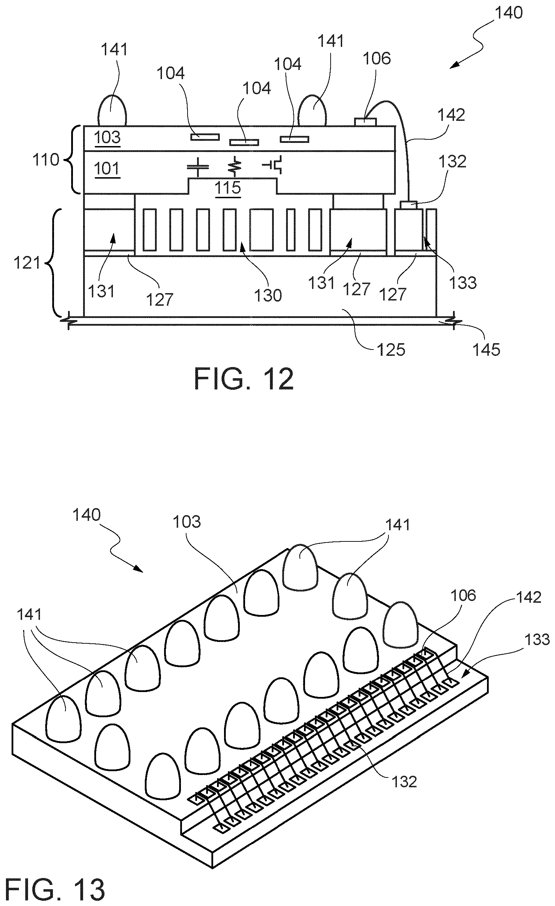

In Figure 12, the composite die 140 is fixed to a tape 145, generally adhesive, having other composite dice 140 fixed thereto (in a manner not shown), at a mutual distance.

Then, bumps 141 are formed on the first contact pads 105. For example, the bumps 141 may be made by "drop" of balls of an alloy, such as an alloy of Sn, Ag, Cu (SAC alloy), subsequently remelted, or other suitable material. Other techniques for forming bumps, known to the person skilled in the art, are also usable.

According to a different solution, the bumps 141 may be formed before dicing the composite wafer 100, at wafer level.

Furthermore, before or preferably after singulation, bonding wires 142 are formed and electrically couple the second contact pads 106 to the third contact pads 132 ("wirebonding") .

Figure 13 shows in top perspective view the composite die 140 thus obtained.

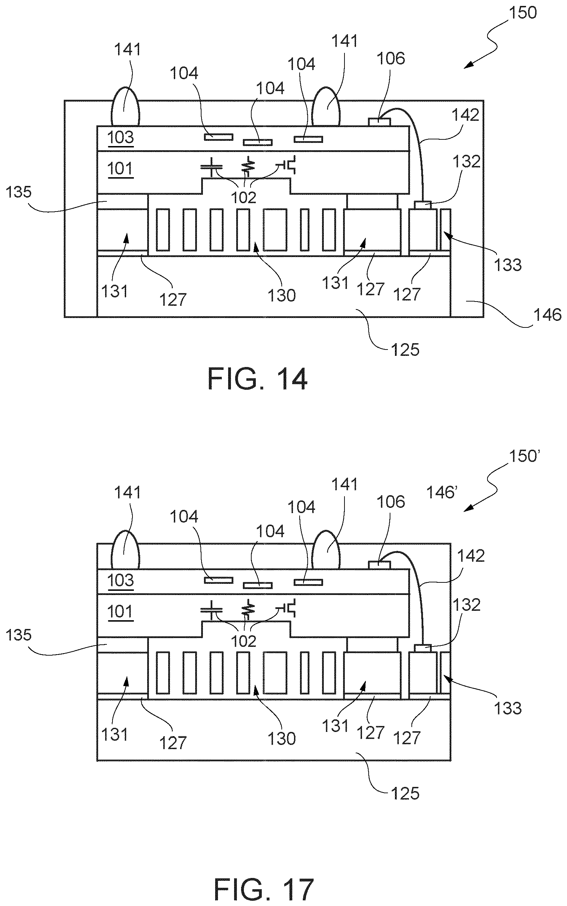

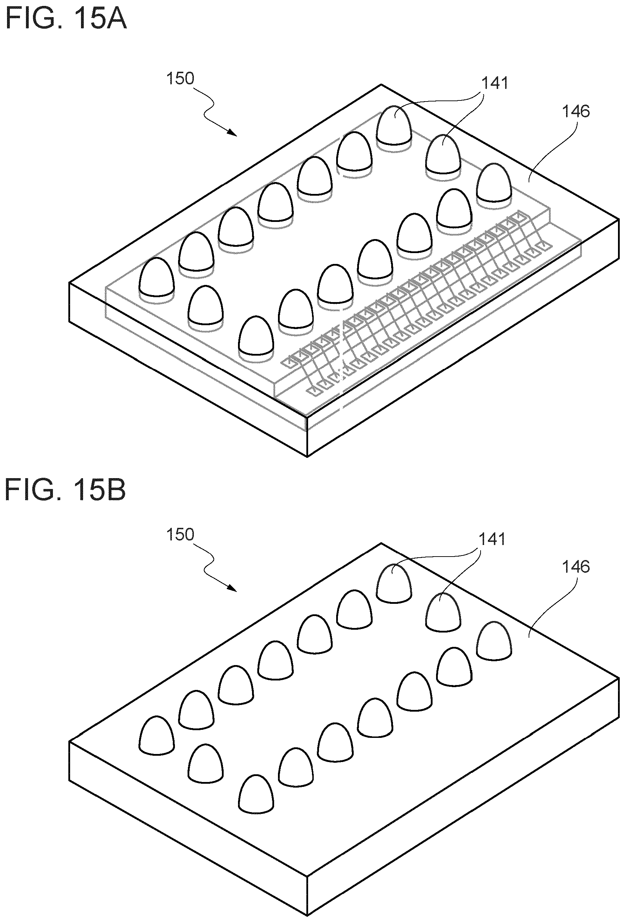

In Figure 14, the composite die 140 (together with the adjacent dice arranged on the same tape 145) is packaged in a sealing mass 146, for example of resin. The structure thus obtained is subsequently singulated, obtaining packaged devices 150, each forming a MEMS device, as visible in Figures 15A, 15B showing the packaged devices in ghost and, respectively, in an external perspective view.

In the packaged device 150 of Figure 14, the sealing mass 146 completely covers the passivation layer 103 and the sides of the composite die 140 and laterally surrounds the bottom part of the bumps 141. The sealing mass 146 also fits into the through opening 139 and completely incorporates the wire bondings 142. The end of the bumps 141 therefore protrudes from the sealing mass 146 and allows the electrical connection of the packaged device 150, in a per se known manner.

In this manner, the packaged devices 150 are protected by the sealing mass 146 both upwardly and laterally and are contactable from the top side.

Thanks to the thickness reduction of the ASIC wafer 110 and of the MEMS wafer 121, to the formation of the cap by the ASIC wafer 110 and to the removal of the carrier wafer 112, the packaged device 150 may have an extremely reduced thickness. For example, the packaged device 150 may have an overall height of 360 µm, with a height of the assembly MEMS region 121 + ASIC region 110 of 250 µm, a thickness of the sealing mass 146 above the ASIC region 110 of 110 µm and a bump 141 protruding by 70 µm from the sealing mass 146.

The assembly formed by MEMS region 121 and ASIC region 110 forms a single chip, with the MEMS part and the ASIC part mechanically and functionally integral. The packaged device 150 is therefore operationally reliable.

The packaged device 150 may be formed using manufacturing steps common to this type of devices and not complex, without using through vias, therefore at low costs and with good control. The final device therefore has comparatively low costs.

Owing to the possibility of forming one or more through openings 139 in different peripheral positions, the third contact pads 132 may be arranged on different sides of the ASIC region 110 or even in any position of the surface, in case of masked etchings of the through openings 139, providing the designer with a wide degree of layout freedom.

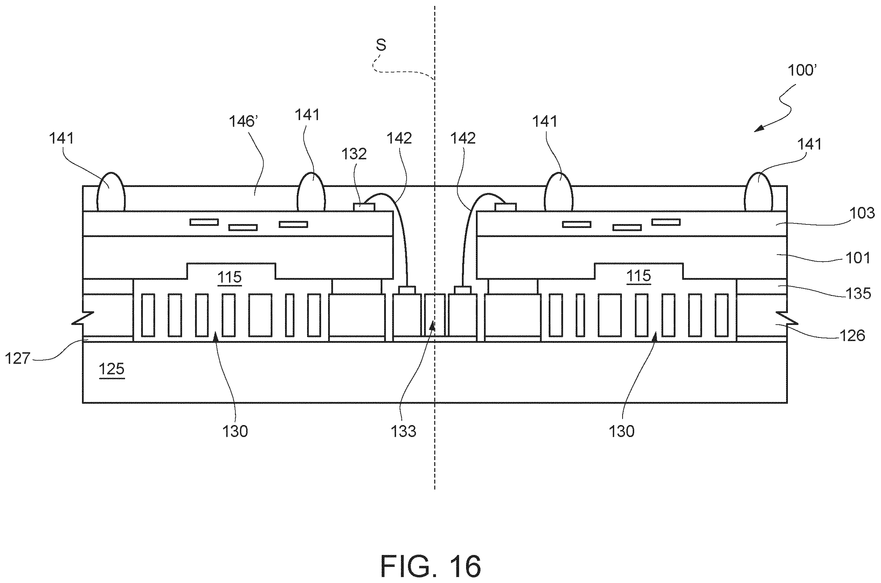

Figure 16 shows a solution where the composite wafer 100 is not singulated after the removal of the carrier wafer 112 (Figure 7), the removal of the residues of the carrier wafer bonding layer 111 (Figure 8) and the formation of the through opening 139 in the ASIC wafer 110 (Figure 9) but is packaged at the wafer level.

In detail, as shown in Figure 16, the composite wafer 100 of Figure 9 is processed to form the bumps 141 and the bonding wires 142. Subsequently, a sealing mass 146' is printed on the composite wafer (here indicated by 100'), and covers the top part thereof.

Subsequently, Figure 17, the composite wafer 100' is singulated, to form a plurality of packaged devices 150'.

As is noted in Figure 17, in this case the sealing mass 146' covers the top part of the device 150' and only part of its sides (zone of the ASIC region 110 and of the bonding wires 142).

In practice, with the package at the chip level, shown in Figures 10-14, a more complete protection is obtained by the sealing mass 146, while with the package at the wafer level, shown in Figures 16-17, the number of singulation operations and therefore the manufacturing cost are reduced.

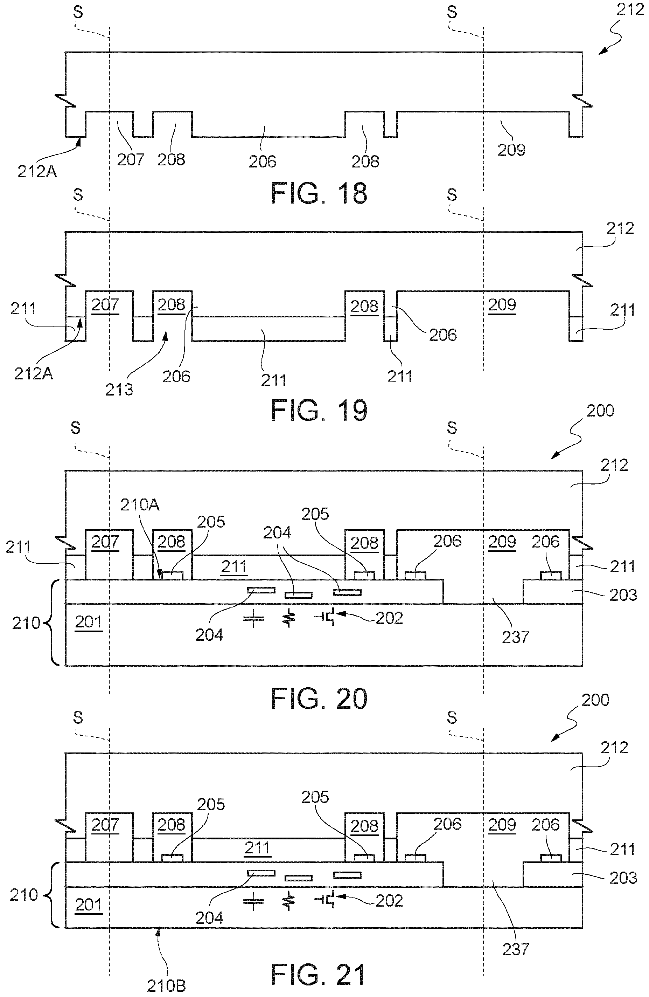

Figures 18-30 show steps of a manufacturing process according to an embodiment. In these Figures, parts similar to those of Figures 1-15 are indicated with reference numbers increased by 100.

In Figure 18, a carrier wafer 212 of semiconductor material, such as silicon, has already been processed to form a first, a second and a third recess 207, 208 and 209.

For example, the carrier wafer 212 may be thermally oxidized, so as to form a protection layer (not shown) which coats it completely, also on the side edges; then the protection layer (not shown) is etched on one face thereof using a resist mask (not shown) to form openings where it is desired to form the recesses 207-209; the resist mask is removed; the carrier wafer 212 is etched using the protection layer (not shown) as a hard mask; then the protective layer is removed.

The carrier wafer 212 therefore has a main face 212A having at least one first recess 207 (intended to be arranged at a scribe line S), the second recesses 208 (intended to allow the electrical connection of the bumps -still to be formed), and the third recess 209 (intended to be arranged at a scribe line S and to allow the connection between the ASIC wafer to be bonded and the MEMS wafer, as explained below) .

The recesses 207-209 are separated by protruding portions 206 of the carrier wafer 212.

In Figure 19, a carrier wafer bonding layer 211, patterned, is printed on the protruding portions 206. For example, the carrier wafer bonding layer 211 is of glass frit or metal. However, other application techniques are possible.

The carrier wafer bonding layer 211 forms openings 213, aligned with the recesses 207-209 and subsequently useful, as explained below.

In Figure 20, an ASIC wafer 210 is bonded to the carrier wafer 212, front-to-front, using the carrier wafer bonding layer 211.

Similarly to the embodiment of Figures 1-15, the ASIC wafer 210 has already been processed so as to form, in a body 201 of semiconductor such as silicon, electronic components 202; form a passivation layer 203 embedding metallizations 204; and form first contact pads 205 on the passivation layer 203.

In Figure 20, the passivation layer 203 has also already been selectively removed (for example through an etching and lithographic process) so as to form a contact opening 237 which, after bonding the ASIC wafer 210 and the carrier wafer 212, is aligned with the third recess 209, although, here, it is narrower.

Furthermore, the main face 212A of the carrier wafer 212 is bonded to the front surface 210A of the ASIC wafer 210 so that the recesses 207-209 are arranged at the first contact pads 205.

A composite wafer 200 is thus formed, where the openings 213 in the carrier wafer bonding layer 211 are superimposed on the first contact pads 205.

In Figure 21, the body 201 is thinned and polished from the back, so as to reach a reduced thickness, for example 120 µm. A rear surface 210B of the ASIC wafer 210 is thus formed.

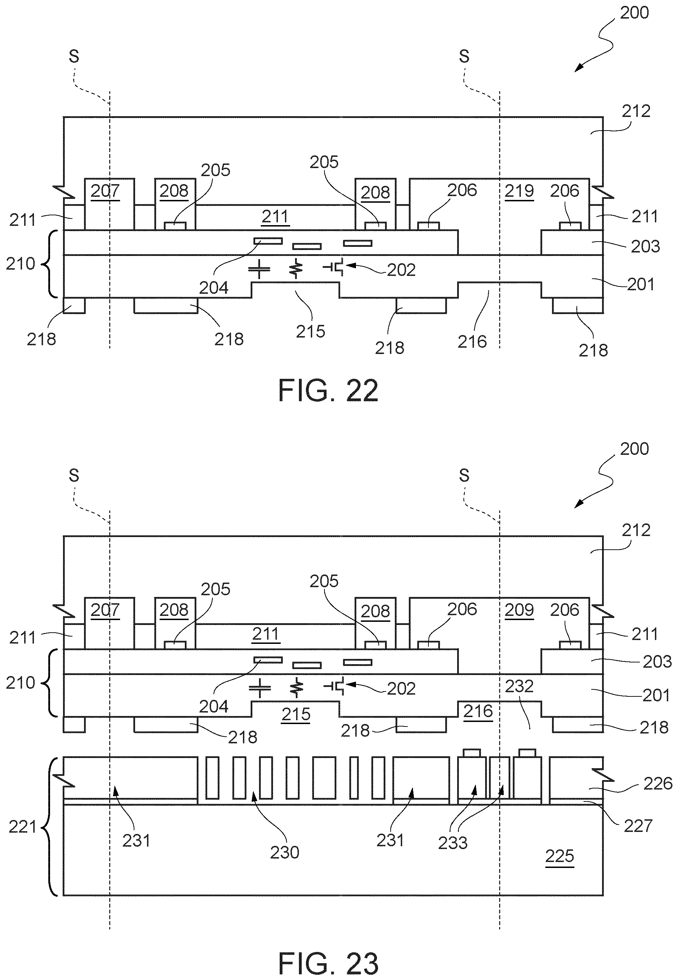

In Figure 22, a first cavity 215 and a second cavity 216 are formed into the body 201, from the rear surface 210B. Also here a photolithographic process and a masked etching of the silicon may be used.

Furthermore, in Figure 22, bonding regions 218 are formed on the rear surface 210B of the ASIC wafer 210. For example, the bonding regions 218 may be of glass frit, selectively printed on the sides of the cavities 215, 216.

In Figure 23, the ASIC wafer 210 is bonded to a MEMS wafer 221 through the bonding regions 218, for example at 270°C. Alternatively, bonding regions of adhesive material may be formed both on the ASIC wafer 210 and on the MEMS wafer 221. The composite wafer thus obtained is again indicated by 200.

Also in this case, in the embodiment shown, the MEMS wafer 221 comprises a first and a second semiconductor layer 225 and 226, for example both of silicon, mutually superimposed and mutually fixed by dielectric regions 227.

Also here, the MEMS wafer 221 has already been processed so as to form, in the second semiconductor layer 226, MEMS sensitive regions, indicated generically by 230 and supported by suspension structures not shown.

The second semiconductor layer 226 also forms anchoring regions 231 and fixed portions 233.

Similarly to the embodiment of Figures 1-15, third contact pads 232 extend on some fixed portions 233 of the MEMS wafer 221.

Also here, the geometry is designed so that bonding of the ASIC wafer 201 to the MEMS wafer 221 is performed so that the first cavity 215 faces the suspended structures 230 and the second cavity 216 faces the third contact pads 232.

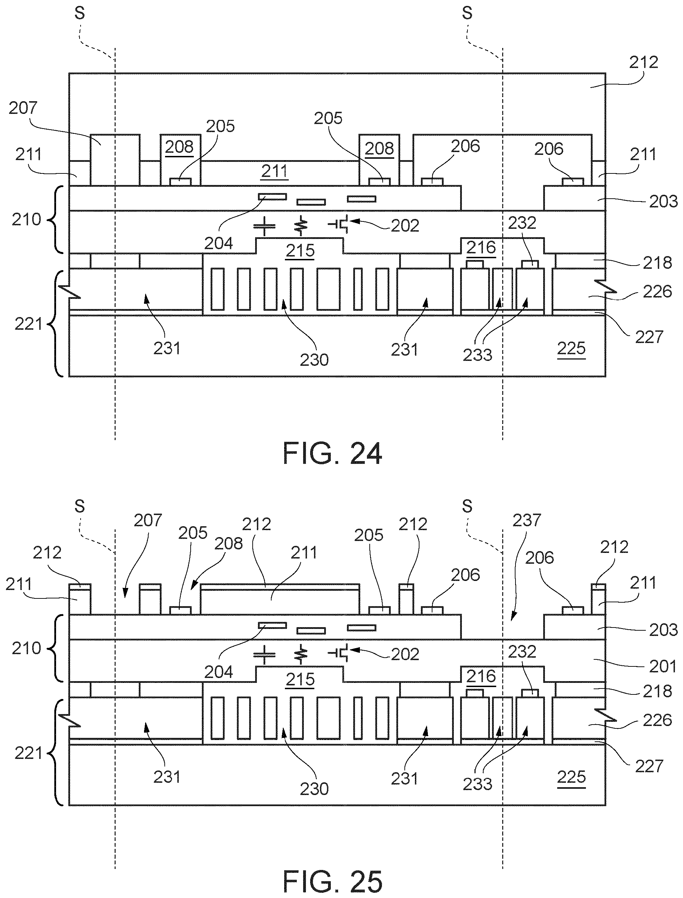

After the bonding (Figure 24), the composite wafer 200 is thinned from the back, so as to reduce the thickness of the first semiconductor layer 225 of the MEMS wafer 212 down to a reduced value, for example 100-120 µm.

In Figure 25, the carrier wafer 212 is thinned to reach at least the bottom of the recesses 207-209, which therefore form through openings (again indicated for sake of simplicity by 207-209), which allow access to the contact pads 205.

For example, after the thinning, the carrier wafer 212 may have a thickness of 10-50 µm.

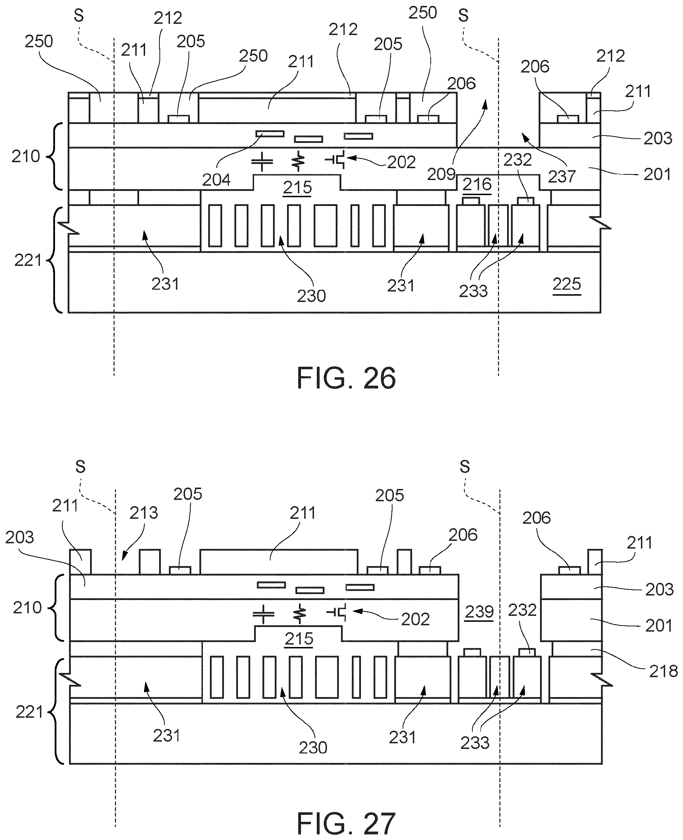

Then, Figure 26, masking regions 250 are formed in the recesses 207-209. To this end, a masking layer, for example of resist, may be deposited above the carrier wafer 212, using a suitable technique, for example by spinning. The masking layer is selectively removed. In particular, it is removed on the contact opening 237, leaving the masking regions 250 in the first recess 207 and in the second recesses 208 and only partially in the third recess 209. The body 201 is therefore here exposed through the contact opening 237.

In Figure 27, the body 201 is selectively etched and removed throughout its thickness, where exposed, here below the third recess 209 and the contact opening 237. A through opening 239 is thus formed which incorporates part of the third recess 209 and the contact opening 237 and makes the third contact pads 232 accessible from the outside.

Etching of the body 201 also leads to removing the remaining portion of the carrier wafer 212.

After removing the masking regions 250, the structure of Figure 27 is obtained.

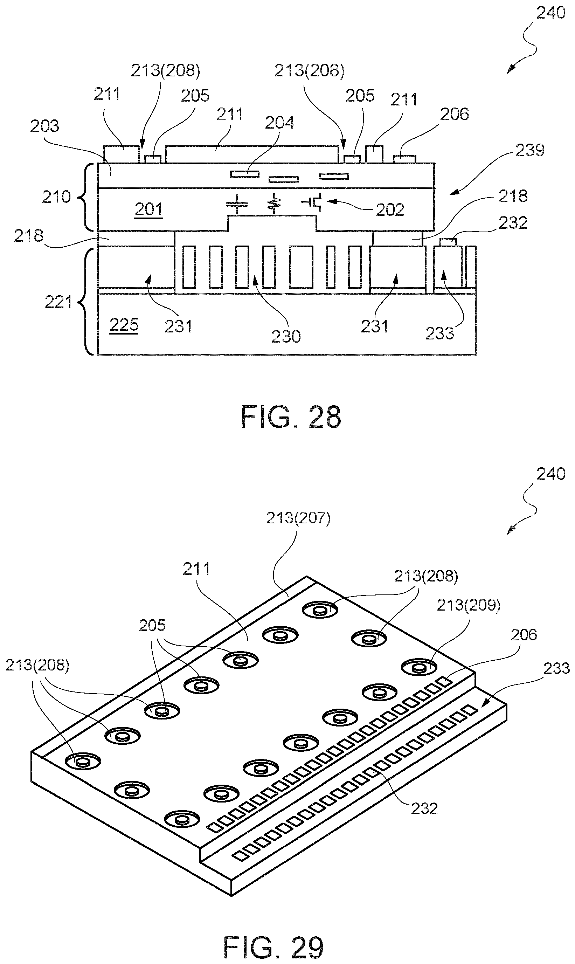

In Figure 28, the composite wafer 200 is singulated along the scribe central lines S. Also here, dicing may occur using a dicing saw or by laser dicing, in a per se known manner, and leads to obtaining a composite die 240.

Figure 29 shows in top perspective view the composite die 240 thus obtained. In this Figure, the openings 213 in the carrier wafer bonding layer 211 are clearly visible.

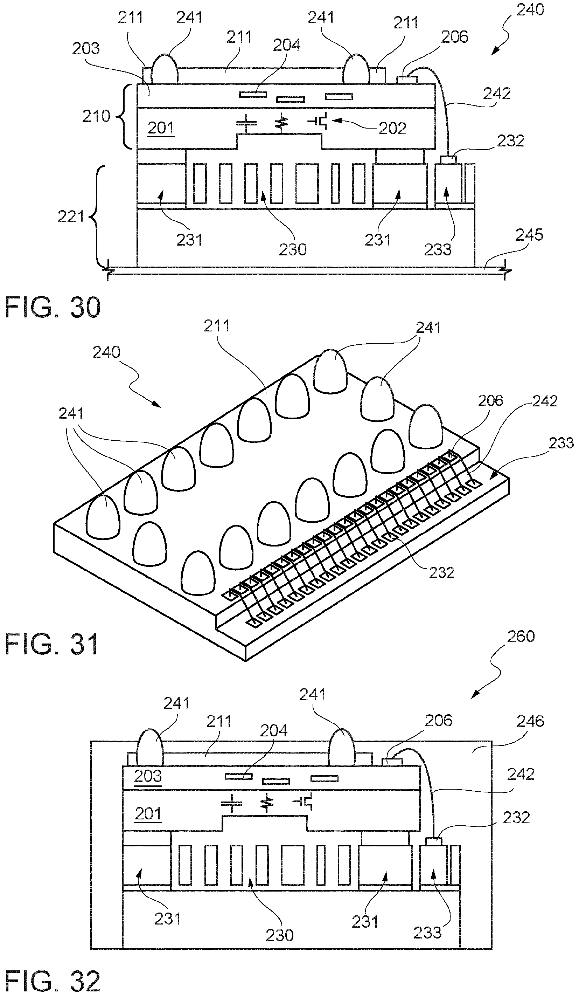

In Figure 30, the composite die 240 is fixed to a tape 245, generally adhesive, having other composite dice 240 fixed thereto (in a manner not shown), at a mutual distance.

Then, bumps 241 are formed on the first contact pads 205. For example, the bumps 141 may be formed as explained above for the bumps 141 of Figure 12.

Furthermore, bonding wires 242 are formed which electrically couple the second contact pads 206 to the third contact pads 232 ("wirebonding").

As an alternative to what has been shown, the bumps 241 and/or the bonding wires 242 may be formed before dicing the composite wafer 200, at wafer level, after the step of Figure 27.

Analogously, the sealing mass 246 may be printed before dicing the composite wafer 200, at wafer level.

Figure 31 shows in top perspective view the composite die 240 thus obtained. In this Figure, the carrier wafer bonding layer 211, bumps 241 and the wires 242 are clearly visible.

In Figure 32, the composite die 240 is packaged by a sealing mass 246, for example of resin. The structure thus obtained is subsequently singulated, obtaining packaged devices 260, each forming a MEMS system.

Also the packaged device 260 thus obtained has a very reduced height, up to 360 µm, thanks to the complete removal of the carrier wafer, the reduced height of the carrier wafer bonding layer 211 (which remains completely embedded in the sealing mass 246), and to the formation of external connections through bumps.

The packaged device 260 may also be manufactured using manufacturing steps common in this type of devices and not complex, at comparatively low costs.

The device has a wide layout flexibility, with contact pads that may be arranged on different sides and without particular constraints as regards the positioning of the bumps.

Finally, it is clear that modifications and variations may be made to the device and the manufacturing process described and illustrated herein without thereby departing from the scope of the present invention, as defined in the attached claims.

Furthermore, if allowed by the nature of the MEMS structures in the MEMS wafer 121, 221 and the thickness of the carrier wafer bonding layer 111, 211, the MEMS device may not have the cavities 115, 116; 215, 216.

Although more complicated, in the solution of Figures 17-32, the carrier wafer bonding layer 211 might be formed on the ASIC wafer 210.

## Claims

1. A process for manufacturing a microelectromechanical device comprising:
bonding a first wafer (210) of semiconductor to a second wafer (212), the first wafer integrating electronic components (202);
thinning the first wafer (210);
bonding the first wafer (210) to a third wafer (221), the third wafer including patterned structures (230);
thinning the third wafer (221);
removing the second wafer (212) to obtain a composite wafer (200) having a main surface (210A) formed by the first wafer;
electrically coupling the first wafer (210) and the third wafer (221) through internal electrical coupling structures (242);
forming external connection regions (241) on the main surface (210A); and
forming a package (246) packaging the first wafer (210), the third wafer (221) and the internal electrical coupling structures (242) and partially surrounding the external connection regions (241), the external connection regions protruding partially from the package,
further comprising, before bonding the first wafer (210) to the second wafer (212), forming first and second recesses (207, 208) in the second wafer and forming contact regions (205) on the main surface (210A) of the first wafer, wherein:
bonding the first wafer (210) to the second wafer (212) comprises forming a bonding layer (211) having first bonding layer openings (213) at the first and second recesses (207, 208) and arranging the first and second recesses (207, 208) of the second wafer and the first bonding layer openings (213) at the contact regions (205) of the first wafer;
removing the second wafer (212) comprises thinning the second wafer (212) up to reaching the first and second recesses (207, 208), forming through recesses (207, 208),
the external connection regions (241) formed on the contact regions (205).

2. The process according to claim 1, wherein the first wafer (210) is an ASIC - Application Specific Integrated Circuit - wafer and the third wafer (221) is a MEMS - Micro-Electro-Mechanical-System - wafer.

3. The process according to claim 1 or 2, wherein the second wafer (212) is of semiconductor or glass.

4. The process according to any of claims 1-3, wherein forming external connection regions comprises forming bumps (241) in the first bonding layer openings (213).

5. The process according to any of the preceding claim, further comprising, before bonding the first wafer (210) to the second wafer (212), forming third recesses (209) in the second wafer; wherein bonding the first wafer (210) to the second wafer (212) further comprises forming second bonding layer openings (213) at the third recesses (209); after the step of removing the second wafer (212), removing a portion of the body (201) below the third recesses (209), forming through openings (239) in the body (210); and electrically coupling the first wafer (210) and the third wafer (221) comprises forming coupling wires (242) extending between contact regions (206) on the main surface (210A) of the first wafer (210) and contact regions (232) extending on the third wafer (221) below the through openings (239).

6. The process according to any of the preceding claims, wherein the external connection regions are bumps and form an LGA - Land Grid Array - interface.

7. The process according to any of claims 1-5, wherein the internal electrical coupling structures are bonding wires (242) extending between external contact pads (206) formed on the main surface (210A) of the first wafer (210) and further contact pads (232) formed on the third wafer (221).

8. The process according to any of the preceding claims, further comprising forming cavities (116) in the first wafer (210) before bonding the first wafer to the third wafer (221).

9. The process according to any of claims 1-4, wherein the third wafer (221) comprises third contact pads (232) facing the first wafer (210), the process further comprising, after the step of removing the second wafer (212), selectively removing a portion of the body (201) above the third contact pads (232), wherein electrically coupling the first wafer (210) and the third wafer (221) comprises forming coupling wires passing through the removed portion of the body (201).

10. The process according to any of the preceding claims, comprising singulating the composite wafer (200) before or after the steps of electrically coupling the first and the third wafers (210; 221), forming external connection regions (241) and forming a package (246).

11. A device comprising:
a first die (210) of semiconductor integrating electronic components (202), the first die having a main surface (210A) and contact regions (205) on the main surface (210A);
a second die (221) of semiconductor bonded to the first die and forming patterned structures (230);
a bonding layer (211) on the main surface (210A) of the first die (210), the bonding layer (211) having first bonding layer openings (213) at the contact regions (205) of the first die;
internal electrical coupling structures (242) electrically coupling the main surface (210A) of the first die (210) to the second die (221);
external connection regions (241) on the contact regions (205) on the main surface of the first die (210), the external connection regions (241) comprising bumps (241) extending in the first bonding layer openings (213); and
a package (246) embedding the first die (210), the second die (221) and the internal electrical coupling structures (242) and partially surrounding the external connection regions (241), the external connection regions protruding partially from the package.

12. The device according to the preceding claim, wherein the package (246) covers and is in contact with the main surface (210A) of the first die (210).

13. The device according to claim 11, further comprising a bonding layer (211) superimposed on the main surface (210A) of the first die (210), wherein the package (246) covers and is in contact with the bonding layer (211).

## Patentansprüche

1. Verfahren zur Herstellung einer mikroelektromechanischen Vorrichtung, umfassend:
Verkleben eines ersten Wafers (210) aus Halbleiter mit einem zweiten Wafer (212), wobei der erste Wafer elektronische Komponenten (202) integriert;
Verdünnen des ersten Wafers (210);
Verkleben des ersten Wafers (210) mit einem dritten Wafer (221), wobei der dritte Wafer gemusterte Strukturen (230) enthält;
Verdünnen des dritten Wafers (221);
Entfernen des zweiten Wafers (212), um einen Verbundwafer (200) mit einer Hauptfläche (210A), die durch den ersten Wafer gebildet wird, zu erhalten;
elektrisches Koppeln des ersten Wafers (210) und des dritten Wafers (221) durch interne elektrische Kopplungsstrukturen (242);
Bilden von äußeren Verbindungsbereichen (241) auf der Hauptfläche (210A); und
Bilden einer Verpackung (246), die den ersten Wafer (210), den dritten Wafer (221) und die inneren elektrischen Kopplungsstrukturen (242) umschließt und die äußeren Verbindungsbereiche (241) teilweise umgibt, wobei die äußeren Verbindungsbereiche teilweise aus der Verpackung hervorstehen,
ferner umfassend, vor dem Verkleben des ersten Wafers (210) mit dem zweiten Wafer (212), das Bilden erster und zweiter Vertiefungen (207, 208) in dem zweiten Wafer und das Bilden von Kontaktbereichen (205) auf der Hauptfläche (210A) des ersten Wafers, wobei:
das Verkleben des ersten Wafers (210) mit dem zweiten Wafer (212) das Bilden einer Klebeschicht (211), die erste Klebeschichtöffnungen (213) an der ersten und der zweiten Vertiefung (207, 208) aufweist, und das Anordnen der ersten und der zweiten Vertiefung (207, 208) des zweiten Wafers und der ersten Klebeschichtöffnungen (213) an den Kontaktbereichen (205) des ersten Wafers umfasst;
das Entfernen des zweiten Wafers (212) das Verdünnen des zweiten Wafers (212) bis zum Erreichen der ersten und der zweiten Vertiefung (207, 208) umfasst, wobei durch die Vertiefungen (207, 208),
die auf den Kontaktbereichen (205) gebildeten äußeren Verbindungsbereiche (241) gebildet werden.

2. Verfahren nach Anspruch 1, wobei der erste Wafer (210) ein ASIC(Application Specific Integrated Circuit)-Wafer ist und der dritte Wafer (221) ein MEMS(Micro-Electro-Mechanical-System)-Wafer ist.

3. Verfahren nach Anspruch 1 oder 2, wobei der zweite Wafer (212) aus Halbleiter oder Glas besteht.

4. Verfahren nach einem der Ansprüche 1 bis 3, wobei das Bilden von äußeren Verbindungsbereichen das Bilden von Erhebungen (241) in den ersten Klebeschichtöffnungen (213) umfasst.

5. Verfahren nach einem der vorhergehenden Ansprüche, ferner umfassend, vor dem Verkleben des ersten Wafers (210) mit dem zweiten Wafer (212), das Bilden dritter Vertiefungen (209) in dem zweiten Wafer; wobei das Verkleben des ersten Wafers (210) mit dem zweiten Wafer (212) ferner das Bilden zweiter Klebeschichtöffnungen (213) an den dritten Vertiefungen (209) umfasst; nach dem Schritt des Entfernens des zweiten Wafers (212) das Entfernen eines Teils des Körpers (201) unterhalb der dritten Vertiefungen (209), wodurch im Körper (210) Durchgangsöffnungen (239) gebildet werden; und wobei das elektrische Koppeln des ersten Wafers (210) und des dritten Wafers (221) das Bilden von Kopplungsdrähten (242) umfasst, die sich zwischen Kontaktbereichen (206) auf der Hauptfläche (210A) des ersten Wafers (210) und Kontaktbereichen (232), die sich auf dem dritten Wafer (221) unterhalb der Durchgangsöffnungen (239) erstrecken, erstrecken.

6. Verfahren nach einem der vorhergehenden Ansprüche, wobei die äußeren Verbindungsbereiche Erhebungen sind und eine LGA(Land Grid Array)-Schnittstelle bilden.

7. Verfahren nach einem der Ansprüche 1 bis 5, wobei die internen elektrischen Kopplungsstrukturen Verbindungsdrähte (242) sind, die sich zwischen äußeren Kontaktpads (206), die auf der Hauptfläche (210A) des ersten Wafers (210) gebildet sind, und weiteren Kontaktpads (232), die auf dem dritten Wafer (221) gebildet sind, erstrecken.

8. Verfahren nach einem der vorhergehenden Ansprüche, ferner umfassend das Bilden von Hohlräumen (116) in dem ersten Wafer (210) vor dem Verkleben des ersten Wafers mit dem dritten Wafer (221).

9. Verfahren nach einem der Ansprüche 1 bis 4, wobei der dritte Wafer (221) dritte Kontaktpads (232) umfasst, die dem ersten Wafer (210) zugewandt sind, wobei das Verfahren ferner nach dem Schritt des Entfernens des zweiten Wafers (212) das selektive Entfernen eines Teils des Körpers (201) oberhalb der dritten Kontaktpads (232) umfasst, wobei das elektrische Koppeln des ersten Wafers (210) und des dritten Wafers (221) das Bilden von Kopplungsdrähten umfasst, die durch den entfernten Teil des Körpers (201) verlaufen.

10. Verfahren nach einem der vorhergehenden Ansprüche, umfassend das Vereinzeln des Verbundwafers (200) vor oder nach den Schritten des elektrischen Koppelns des ersten und des dritten Wafers (210; 221), das Bilden von äußeren Verbindungsbereichen (241) und das Bilden einer Verpackung (246).

11. Vorrichtung, umfassend:
eine erste Matrize (210) aus Halbleiter, die elektronische Komponenten (202) integriert, wobei die erste Matrize eine Hauptfläche (210A) und Kontaktbereiche (205) auf der Hauptfläche (210A) aufweist;
eine zweite Matrize (221) aus Halbleiter, die mit der ersten Matrize verbunden ist und gemusterte Strukturen (230) bildet;
eine Klebeschicht (211) auf der Hauptfläche (210A) der ersten Matrize (210), wobei die Klebeschicht (211) erste Klebeschichtöffnungen (213) an den Kontaktbereichen (205) der ersten Matrize aufweist;
interne elektrische Kopplungsstrukturen (242) zur elektrischen Kopplung der Hauptfläche (210A) der ersten Matrize (210) mit der zweiten Matrize (221);
äußere Verbindungsbereiche (241) an den Kontaktbereichen (205) auf der Hauptfläche der ersten Matrize (210), wobei die äußeren Verbindungsbereiche (241) Erhebungen (241) umfassen, die sich in den ersten Klebeschichtöffnungen (213) erstrecken; und
eine Verpackung (246), die die erste Matrize (210), die zweite Matrize (221) und die inneren elektrischen Kopplungsstrukturen (242) einbettet und die äußeren Verbindungsbereiche (241) teilweise umgibt, wobei die äußeren Verbindungsbereiche teilweise aus der Verpackung hervorstehen.

12. Vorrichtung nach dem vorhergehenden Anspruch, wobei die Verpackung (246) die Hauptfläche (210A) der ersten Matrize (210) abdeckt und mit ihr in Kontakt steht.

13. Vorrichtung nach Anspruch 11, ferner umfassend eine auf die Hauptfläche (210A) der ersten Matrize (210) überlagerte Klebeschicht (211), wobei die Verpackung (246) die Klebeschicht (211) abdeckt und mit ihr in Kontakt steht.

## Revendications

1. Procédé de fabrication d'un dispositif microélectromécanique comprenant :
le collage d'une première tranche (210) de semi-conducteur à une deuxième tranche (212), la première tranche intégrant des composants électroniques (202) ;
l'amincissement de la première tranche (210) ;
le collage de la première tranche (210) à une troisième tranche (221), la troisième tranche incluant des structures à motifs (230) ;
l'amincissement de la troisième tranche (221) ;
l'élimination de la deuxième tranche (212) pour obtenir une tranche composite (200) présentant une surface principale (210A) formée par la première tranche ;
le couplage électrique de la première tranche (210) et de la troisième tranche (221) par l'intermédiaire de structures de couplage électrique internes (242) ;
la formation de régions de connexion externes (241) sur la surface principale (210A); et
la formation d'un boîtier (246) encapsulant la première tranche (210), la troisième tranche (221) et les structures de couplage électrique internes (242) et entourant partiellement les régions de connexion externes (241), les régions de connexion externes faisant partiellement saillie hors du boîtier,
comprenant en outre, avant le collage de la première tranche (210) à la deuxième tranche (212), la formation de premiers et deuxièmes évidements (207, 208) dans la deuxième tranche et la formation de régions de contact (205) sur la surface principale (210A) de la première tranche, dans lequel :
le collage de la première tranche (210) à la deuxième tranche (212) comprend la formation d'une couche de collage (211) présentant des premières ouvertures de couche de collage (213) au niveau des premiers et deuxièmes évidements (207, 208) et l'agencement des premiers et deuxièmes évidements (207, 208) de la deuxième tranche et des premières ouvertures de couche de collage (213) au niveau des régions de contact (205) de la première tranche ;
l'élimination de la deuxième tranche (212) comprend l'amincissement de la deuxième tranche (212) jusqu'à atteindre les premiers et deuxièmes évidements (207, 208), formant des évidements traversants (207, 208),
les régions de connexion externes (241) sont formées sur les régions de contact (205).

2. Procédé selon la revendication 1, dans lequel la première tranche (210) est une tranche ASIC - circuit intégré client - et la troisième tranche (221) est une tranche MEMS - microsystème électromécanique.

3. Procédé selon la revendication 1 ou 2, dans lequel la deuxième tranche (212) est constituée d'un semi-conducteur ou d'un verre.

4. Procédé selon n'importe laquelle des revendications 1 à 3, dans lequel la formation de régions de connexion externes comprend la formation de plots (241) dans les premières ouvertures de couche de collage (213).

5. Procédé selon n'importe laquelle des revendications précédentes, comprenant en outre, avant le collage de la première tranche (210) à la deuxième tranche (212), la formation de troisièmes évidements (209) dans la deuxième tranche ; dans lequel le collage de la première tranche (210) à la deuxième tranche (212) comprend en outre la formation de deuxièmes ouvertures de couche de collage (213) au niveau des troisièmes évidements (209) ; après l'étape d'élimination de la deuxième tranche (212), l'élimination d'une portion du corps (201) au-dessous des troisièmes évidements (209), formant des ouvertures traversantes (239) dans le corps (210) ; et le couplage électrique de la première tranche (210) et de la troisième tranche (221) comprend la formation de fils de couplage (242) s'étendant entre des régions de contact (206) sur la surface principale (210A) de la première tranche (210) et des régions de contact (232) s'étendant sur la troisième tranche (221) au-dessous des ouvertures traversantes (239).

6. Procédé selon n'importe laquelle des revendications précédentes, dans lequel les régions de connexion externes sont des plots et forment une interface LGA - boîtier à matrice de plots.

7. Procédé selon n'importe laquelle des revendications 1 à 5, dans lequel les structures de couplage électrique internes sont des fils de connexion (242) s'étendant entre des plages de contact externes (206) formées sur la surface principale (210A) de la première tranche (210) et des plages de contact supplémentaires (232) formées sur la troisième tranche (221).

8. Procédé selon n'importe laquelle des revendications précédentes, comprenant en outre la formation de cavités (116) dans la première tranche (210) avant le collage de la première tranche à la troisième tranche (221).

9. Procédé selon n'importe laquelle des revendications 1 à 4, dans lequel la troisième tranche (221) comprend des troisièmes plages de contact (232) faisant face à la première tranche (210), le procédé comprenant en outre, après l'étape d'élimination de la deuxième tranche (212), l'élimination sélective d'une portion du corps (201) au-dessus des troisièmes plages de contact (232), dans lequel le couplage électrique de la première tranche (210) et de la troisième tranche (221) comprend la formation de fils de couplage passant par la portion éliminée du corps (201).

10. Procédé selon n'importe laquelle des revendications précédentes, comprenant le découpage de la tranche composite (200) avant ou après les étapes de couplage électrique des première et troisième tranches (210 ; 221), de formation de régions de connexion externes (241) et de formation d'un boîtier (246).

11. Dispositif comprenant :
une première puce (210) de semi-conducteur intégrant des composants électroniques (202), la première puce présentant une surface principale (210A) et des régions de contact (205) sur la surface principale (210A);
une deuxième puce (221) de semi-conducteur collée à la première puce et formant des structures à motifs (230) ;
une couche de collage (211) sur la surface principale (210A) de la première puce (210), la couche de collage (211) présentant des premières ouvertures de couche de collage (213) au niveau des régions de contact (205) de la première puce ;
des structures de couplage électrique internes (242) couplant électriquement la surface principale (210A) de la première puce (210) à la deuxième puce (221) ;
des régions de connexion externes (241) sur les régions de contact (205) sur la surface principale de la première puce (210), les régions de connexion externes (241) comprenant des plots (241) s'étendant dans les premières ouvertures de couche de collage (213) ; et
un boîtier (246) encapsulant la première puce (210), la deuxième puce (221) et les structures de couplage électrique internes (242) et entourant partiellement les régions de connexion externes (241), les régions de connexion externes faisant partiellement saillie hors du boîtier.

12. Dispositif selon la revendication précédente, dans lequel le boîtier (246) couvre et est en contact avec la surface principale (210A) de la première puce (210).

13. Dispositif selon la revendication 11, comprenant en outre une couche de collage (211) superposée sur la surface principale (210A) de la première puce (210), dans lequel le boîtier (246) couvre et est en contact avec la couche de collage (211).
